# EUROPEAN PATENT APPLICATION

(11) **EP 4 657 728 A1**
(43) Date of publication of application: **03.12.2025**
(21) Application number: 24766336.2
(22) Date of filing: 29.02.2024
(51) Int. Cl.: H02M 1/00, H02M 7/00

(54) **ELECTRICAL DEVICE ASSEMBLY, CONTROLLER, AND VEHICLE**

(30) Priority: 03.03.2023 CN 202310238551
(71) Applicant: BYD Company Limited, Shenzhen, Guangdong 518118 (CN)
(72) Inventor: LIAN, Yubo, Shenzhen, Guangdong 518118 (CN); LING, Heping, Shenzhen, Guangdong 518118 (CN); ZHAI, Zhen, Shenzhen, Guangdong 518118 (CN); QI, Weichao, Shenzhen, Guangdong 518118 (CN); TANG, Chengbo, Shenzhen, Guangdong 518118 (CN)
(74) Representative: Taor, Simon Edward William
(86) International application number: PCT/CN2024/079431
(87) International publication number: WO 2024/183616

(57) **Abstract**

A vehicle, having a controller, the controller having an electrical device assembly, the electrical device assembly comprising a first electrical device and a second electrical device, the first electrical device comprising a first electrical device body, a first positive electrode connection terminal, and a first negative electrode connection terminal, and the second electrical device comprising a second electrical device body, a second positive electrode connection terminal and a second negative electrode connection terminal; the first positive electrode connection terminal and the first negative electrode connection terminal being stacked along a second direction; the second positive electrode connection terminal and the second negative electrode connection terminal being stacked along the second direction; the first positive electrode connection terminal being in butt joint with the second positive electrode connection terminal along a first direction; and the first negative electrode connection terminal being in butt joint with the second negative electrode connection terminal along the first direction.

## Description

### CROSS-REFERENCE TO RELATED APPLICATIONS

The present disclosure claims priority to Chinese Patent Application No. 202310238551.0 filed on March 3, 2023, entitled "ELECTRICAL DEVICE MODULE, CONTROL MODULE, AND VEHICLE", which is incorporated herein by reference in its entirety.

### FIELD

The present disclosure relates to the technical field of electrical devices, and in particular, to an electrical device assembly, a controller and a vehicle.

### BACKGROUND

In the related art, after electrical connection between supporting capacitors and power devices, the stray inductance is often relatively high. Higher stray inductance can lead to issues such as power loss or signal attenuation in the circuit system.

### SUMMARY

The present disclosure is intended to provide an electrical device assembly, controller, and vehicle that can solve the technical problems existing in related technologies.

In order to achieve the above objectives, the first aspect of the present disclosure provides an electrical device assembly, which includes:
A first electrical device, which includes a first electrical device body, a first positive electrode connection terminal, and a first negative electrode connection terminal;
A second electrical device, which includes a second electrical device body, a second positive electrode connection terminal, and a second negative electrode connection terminal;
The first positive electrode connection terminal and the first negative electrode connection terminal both protrude form the first electrical device body along a first direction, and the first positive electrode connection terminal and the first negative electrode connection terminal are stacked along a second direction;
The second positive electrode connection terminal and the second negative electrode connection terminal both protrude form the second electrical device body along the first direction, and the second positive electrode connection terminal and the second negative electrode connection terminal are stacked along the second direction;
The first positive electrode connection terminal is partially overlapped and connected with the second positive electrode connection terminal along the second direction; the first negative electrode connection terminal is partially overlapped and connected with the second negative electrode connection terminal along the second direction; wherein the first direction and the second direction intersect.

In some embodiments, a side of the first positive electrode connection terminal away from the first electrical device body along the first direction and a side of the second positive electrode connection terminal away from the second electrical device body along the first direction are partially overlapped and connected along the second direction;
A side of the first negative electrode connection terminal away from the first electrical device body along the first direction and a side of the second negative electrode connection terminal away from the second electrical device body along the first direction are partially overlapped and connected along the second direction.

In some embodiments, the first positive electrode connection terminal includes a first positive electrode connection sheet, the first negative electrode connection terminal includes a first negative electrode connection sheet, the second direction is a thickness direction of the first positive electrode connection sheet and the first negative electrode connection sheet, the first positive electrode connection sheet and the first negative electrode connection sheet are parallel to each other, and a projection of the first positive electrode connection sheet along the second direction is at least partially overlapped with a projection of the first negative electrode connection sheet along the second direction;
The first positive electrode connection sheet and the second positive electrode connection terminal are partially overlapped and connected along the second direction; the first negative electrode connection sheet and the second negative electrode connection terminal are partially overlapped and connected along the second direction.

In some embodiments, the second positive electrode connection terminal includes a second positive electrode connection sheet, and the second negative electrode connection terminal includes a second negative electrode connection sheet; the second direction is a thickness direction of the second positive electrode connection sheet and the second negative electrode connection sheet; a projection of the second positive electrode connection sheet along the second direction is at least partially overlapped with a projection of the second negative electrode connection sheet along the second direction;
The first positive electrode connection sheet and the second positive electrode connection sheet are parallel and staggered along the second direction to achieve partial overlapping connection; the first negative electrode connection sheet and the second negative electrode connection sheet are parallel and staggered along the second direction to achieve partial overlapping connection.

In some embodiments, an overlapping region between the first positive electrode connection sheet and the second positive electrode connection sheet is defined as a first overlapping region; an overlapping region between the first negative electrode connection sheet and the second negative electrode connection sheet is defined as a second overlapping region; the first overlapping region and the second overlapping region are spaced apart along the first direction.

In some embodiments, a length of the first overlapping region and/or a length of the second overlapping region along the first direction is between 2 mm and 8 mm.

In some embodiments, the first positive electrode connection sheet and the second positive electrode connection sheet are connected by fusion, and a first fusion region between the first positive electrode connection sheet and the second positive electrode connection sheet is located within the first overlapping region, a length of the first fusion region along the first direction is between 0.5 mm and 4 mm; and/or,
The first negative electrode connection sheet and the second negative electrode connection sheet are connected by fusion, and a second fusion region between the first negative electrode connection sheet and the second negative electrode connection sheet are located within the second overlapping region, a length of the second fusion region along the first direction (A) is between 0.5 mm and 4 mm.

In some embodiments, a projection of the first positive electrode connection sheet and the second positive electrode connection sheet along the second direction is defined as a first projection; a projection of the first negative electrode connection sheet and the second negative electrode connection sheet along the second direction is defined as a second projection; a length of the first projection along the first direction is equal to a length of the second projection along the first direction.

In some embodiments, a length of the first positive electrode connection sheet along a third direction is equal to a length of the first negative electrode connection sheet along the third direction, wherein the first direction, the second direction, and the third direction are mutually perpendicular; and/or,
A length of the second positive electrode connection sheet along a third direction is equal to a length of the second negative electrode connection sheet along the third direction, wherein the first direction, the second direction, and the third direction are mutually perpendicular; and/or,
In some embodiments, the first electrical device further includes a first insulating portion, the first insulating portion protrudes from the first electrical device body along the first direction and the first insulating portion is located between the first positive electrode connection terminal and the first negative electrode connection terminal;
   the second electrical device further includes a second insulating portion, the second insulating portion protrudes from the second electrical device body along the first direction and the second insulating portion is located between the second positive electrode connection terminal and the second negative electrode connection terminal;
   the first insulating portion and the second insulating portion are at least partially overlapped, and an overlapping region between the first insulating portion and the second insulating portion along the second direction is a first overlapping projection;
   an overlapping region between the first positive electrode connection terminal and the second positive electrode connection terminal along the second direction (B) is a second overlapping projection;
   an overlapping region between the first negative electrode connection terminal and the second negative electrode connection terminal along the second direction is a third overlapping projection;
The second overlapping projection and the third overlapping projection are located within the first overlapping projection.

In some embodiments, the first insulating portion includes a first connecting segment, a second connecting segment, and a third connecting segment which are connected sequentially; the second insulating portion includes a fourth connecting segment, a fifth connecting segment, and a sixth connecting segment which are connected sequentially; the second connecting segment forms an angle with both the first connecting segment and the third connecting segment; the fifth connecting segment forms an angle with both the fourth connecting segment and the sixth connecting segment; the first connecting segment and the fourth connecting segment are arranged in an overlapping configuration; the second connecting segment and the fifth connecting segment are arranged in an overlapping configuration; the third connecting segment and the sixth connecting segment are arranged in an overlapping configuration.

The second aspect of the present disclosure further provides a controller, which includes the electrical device assembly, the first electrical device comprises a capacitor, where the first positive electrode connection terminal serves as the positive electrode output terminal of the capacitor, and the first negative electrode connection terminal serves as the negative electrode output terminal of the capacitor; the second electrical device comprises a power device, where the second positive electrode connection terminal serves as the positive electrode input terminal of the power device, and the second negative electrode connection terminal serves as the negative electrode input terminal of the power device.

The third aspect of the present disclosure further provides a vehicle, which includes the controller or the electrical device assembly
In the above technical solution, the first positive electrode connection terminal of the first electrical device and the second positive electrode connection terminal of the second electrical device are partially overlapped and connected, and the first negative electrode connection terminal of the first electrical device and the second negative electrode connection terminal of the second electrical device are partially overlapped and connected; And the first positive electrode connection terminal and the first negative electrode connection terminal are stacked along the second direction, and the second positive electrode connection terminal and the second negative electrode connection terminal are stacked along the second direction B, the first positive electrode connection terminal, the second positive electrode connection terminal, the first negative electrode connection terminal, and the second negative electrode connection terminal can form an inductive circuit. The first magnetic field generated by the current passing through the first positive electrode connection terminal and the second positive electrode connection terminal can cancel out the second magnetic field generated by the current passing through the first negative electrode connection terminal and the second negative electrode connection terminal. This means that the direction of the magnetic field generated by the current circuit of the first positive electrode connection terminal and the second positive electrode connection terminal is opposite to the direction of the magnetic field generated by the current circuit of the first negative electrode connection terminal and the second negative electrode connection terminal, thereby canceling out the magnetic fields, reducing the generation of stray inductance, and alleviating the loss or signal attenuation caused by the circuit.

Other features and advantages of this disclosure will be described in detail in the subsequent specific implementation section.

### BRIEF DESCRIPTION OF THE DRAWINGS

The accompanying drawings are used to provide further understanding of the present disclosure and form a part of the description. They are used together with the specific embodiments below to explain the present disclosure, but do not constitute limitations on the present disclosure. In the attached figure:
FIG.1 is a schematic diagram of the three-dimensional structure of an electrical device assembly according to an embodiment of the present disclosure.
FIG.2 is a schematic diagram of the three-dimensional structure of an electrical device assembly according to an embodiment of the present disclosure, where the perspective of FIG.2 is different from that of FIG.1.
FIG.3 is a side view of an electrical device assembly according to an embodiment of the present disclosure.
FIG.4 is an enlarged partial view of point D in FIG.3.
FIG.5 is a partial structural schematic diagram of an electrical device assembly according to another embodiment of the present disclosure.
FIG.6 is a schematic diagram of the three-dimensional structure of a first electrical device of an electrical device assembly according to an embodiment of the present disclosure.
FIG.7 is a schematic diagram of the three-dimensional structure of a first electrical device of an electrical device assembly according to an embodiment of the present disclosure, where the perspective of FIG.6 is different from that of FIG.5.
FIG.8 is a side view of a first electrical device of an electrical device assembly according to an embodiment of the present disclosure.
FIG.9 is a schematic diagram of the three-dimensional structure of a second electrical device of an electrical device assembly according to an embodiment of the present disclosure.
FIG.10 is a first view of a second electrical device of an electrical device assembly according to an embodiment of the present disclosure.
FIG.11 is a second view of a second electrical device of an electrical device assembly according to an embodiment of the present disclosure.
FIG.12 is a schematic diagram of a controller according to an embodiment of the present disclosure.
FIG.13 is a schematic diagram of a vehicle according to an embodiment of the present disclosure, wherein the vehicle in the figure includes a controller.
FIG.14 is a schematic diagram of another embodiment of the vehicle disclosed herein, wherein the vehicle includes an electrical device assembly.

### DETAILED DESCRIPTION

The specific embodiments of the present disclosure will be described in detail below with reference to the accompanying drawings. It should be understood that the specific embodiments described herein are only for illustration and explanation of this disclosure, and are not intended to limit this disclosure.

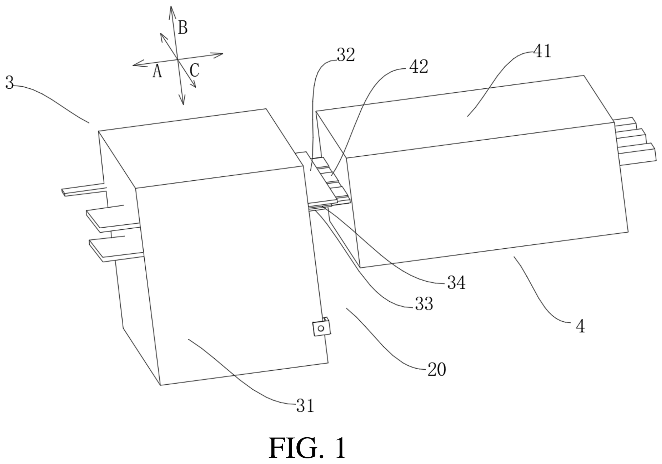

In the present disclosure, unless otherwise specified, directional terms such as "first direction, second direction, and third direction" are defined for the convenience of describing the structure of the electrical device assembly 20 and do not limit the electrical device assembly 20. For details, refer to FIG. 1. Terms such as "first, second" are used only to distinguish one element from another and do not imply any order or importance.

Among the three core systems of new energy vehicles, the controller is one of the most critical components. Within the controller, support capacitors and power devices are the main components. The support capacitor (also called a DC-Link capacitor) primarily protects the power device (e.g., by absorbing ripple currents) and prevents the power device from breakdown due to high voltage. The function of power devices is to convert the power supply output to provide a three-phase power input to the motor.

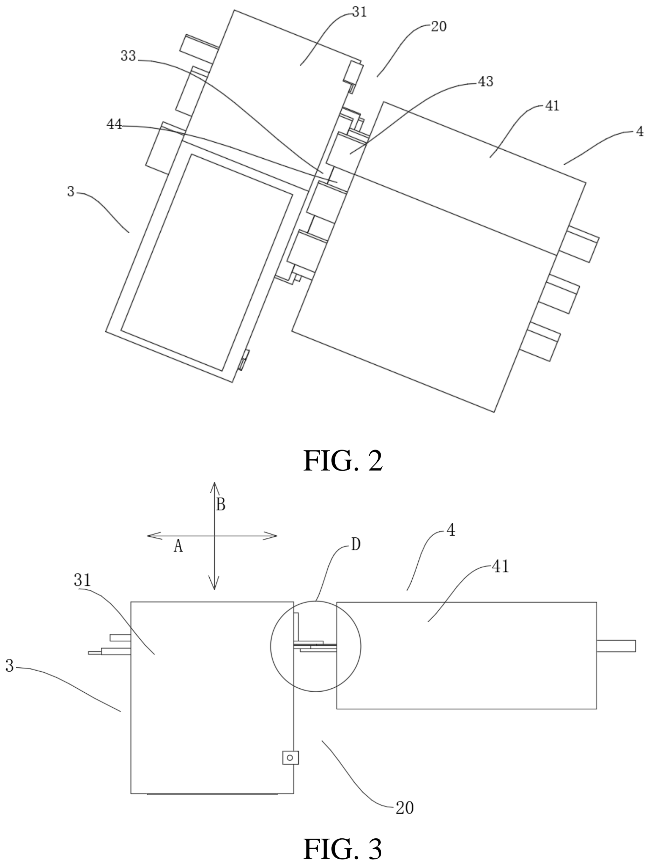

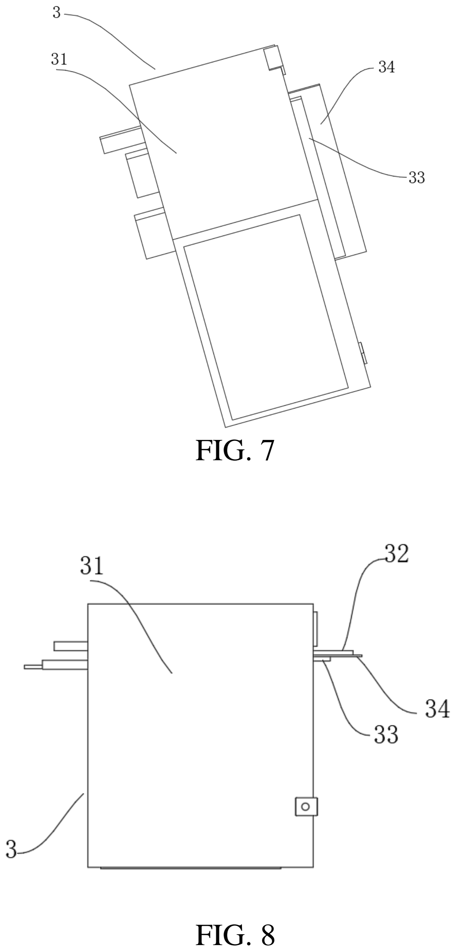

Referring to FIGS. 1 to 11, the present disclosure provides an electrical device assembly 20, which includes a first electrical device 3 and a second electrical device 4. The first electrical device 3 includes a first electrical device body 31, a first positive electrode connection terminal 32, and a first negative electrode connection terminal 33. The second electrical device 4 includes a second electrical device body 41, a second positive electrode connection terminal 42, and a second negative electrode connection terminal 43. The first positive electrode connection terminal 32 and the first negative electrode connection terminal 33 protrude from the first electrical device body 31 along a first direction A and the first positive electrode connection terminal 32 and the first negative electrode connection terminal 33 are stacked along a second direction B. The second positive electrode connection terminal 42 and the second negative electrode connection terminal 43 protrude from the second electrical device body 41 along the first direction A and the second positive electrode connection terminal 42 and the second negative electrode connection terminal 43 are stacked along the second direction B. The first positive electrode connection terminal 32 is partially overlapped and connects with the second positive electrode connection terminal 42 along the second direction B, and the first negative electrode connection terminal 33 is partially overlapped and connects with the second negative electrode connection terminal 43 along the second direction B; wherein the first direction A and the second direction B intersect.

In the above embodiment, the first positive electrode connection terminal 32 of the first electrical device 3 is partially overlapped and connected with the second positive electrode connection terminal 42 of the second electrical device 4, and the first negative electrode connection terminal 33 of the first electrical device 3 is partially overlapped and connected with the second negative electrode connection terminal 43 of the second electrical device 4. Since the first positive electrode connection terminal 32 and the first negative electrode connection terminal 33 are stacked along the second direction B, and the second positive electrode connection terminal 42 and the second negative electrode connection terminal 43 are stacked along the second direction B, the first positive electrode connection terminal 32, the second positive electrode connection terminal 42, the first negative electrode connection terminal 33, and the second negative electrode connection terminal 43 can form an inductive loop. The first magnetic field generated by the current passing through the first positive electrode connection terminal 32 and the second positive electrode connection terminal 42 can cancel out the second magnetic field generated by the current passing through the first negative electrode connection terminal 33 and the second negative electrode connection terminal 43. In other words, the magnetic field direction generated by the current circuit of the first positive electrode connection terminal 32 and the second positive electrode connection terminal 42 is opposite to that generated by the current circuit of the first negative electrode connection terminal 33 and the second negative electrode connection terminal 43, thereby canceling out the magnetic fields, reducing the generation of stray inductance, and alleviating the loss or signal attenuation caused by the circuit.

In one embodiment, referring to FIGS. 1 to 5, a side of the first positive electrode connection terminal 32 away from the first electrical device body 31 along the first direction A and a side of the second positive electrode connection terminal 42 away from the second electrical device body 41 along the first direction A are partially overlapped and connected along the second direction B. Similarly, a side of the first negative electrode connection terminal 33 away from the first electrical device body 31 along the first direction A and a side of the second negative electrode connection terminal 43 away from the second electrical device body 41 along the first direction A are partially overlapped and connected along the second direction B. In this embodiment, the partial overlapping connection may be a direct connection between the two connection terminals or an indirect connection via an intermediate connector (not shown), which is not limited in the present disclosure.

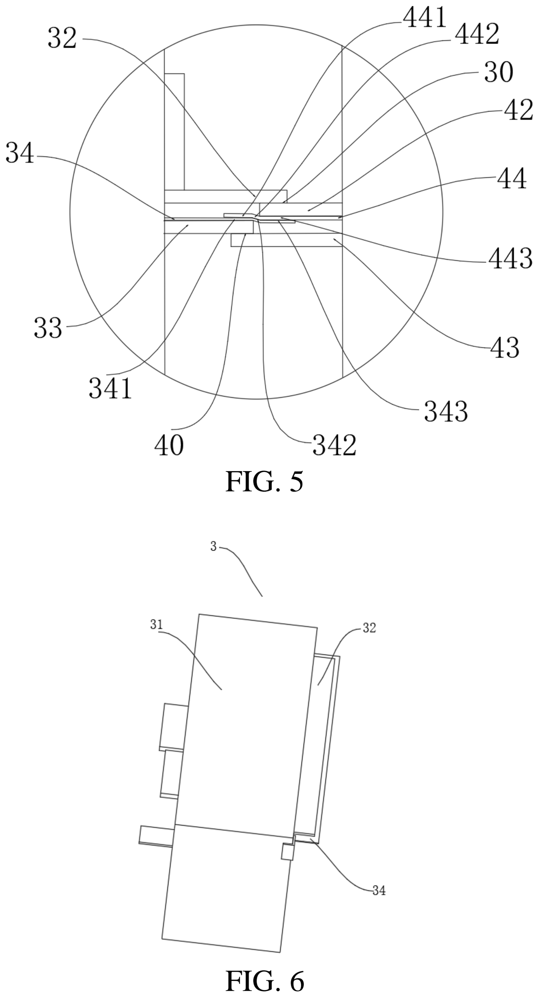

In some embodiments, referring to FIGS. 6 to 8, the first positive electrode connection terminal 32 includes a first positive electrode connection sheet, and the first negative electrode connection terminal 33 includes a first negative electrode connection sheet. The second direction B is a thickness direction of the first positive electrode connection sheet and the first negative electrode connection sheet. The first positive electrode connection sheet and the first negative electrode connection sheet are parallel to each other, and a projection of the first positive electrode connection sheet along the second direction B is at least partially overlapped with a projection of the first negative electrode connection sheet along the second direction B. The first positive electrode connection sheet and the second positive electrode connection terminal 42 are partially overlapped and connected along the second direction B, and the first negative electrode connection sheet and the second negative electrode connection terminal 43 are partially overlapped and connected along the second direction B.

In this embodiment, the first positive electrode connection terminal 32 and the first negative electrode connection terminal 33 are both configured as connection sheet structures, and the second direction B is the thickness direction of the first positive electrode connection sheet and the first negative electrode connection sheet. Additionally, a projection of the first positive electrode connection sheet along the second direction B is at least partially overlapped with a projection of the first negative electrode connection sheet along the second direction B. By stacking the first positive electrode connection sheet and the first negative electrode connection sheet of opposite polarities, the formed inductive loop can be significantly reduced, thereby minimizing the generation of stray inductance. Furthermore, for the second positive electrode connection terminal 42 that is partially overlapped with the first positive electrode connection sheet, the present disclosure does not limit the specific structure of the second positive electrode connection terminal 42, which may be sheet-shaped, rod-shaped, etc. Similarly, the structure of the second negative electrode connection terminal 43 is also not limited.

In other embodiments, referring to FIGS. 1 to 5, the second positive electrode connection terminal 42 includes a second positive electrode connection sheet, and the second negative electrode connection terminal 43 includes a second negative electrode connection sheet. The second direction B is a thickness direction of the second positive electrode connection sheet and the second negative electrode connection sheet, and a projection of the second positive electrode connection sheet along the second direction B is at least partially overlapped with a projection of the second negative electrode connection sheet along the second direction B. The first positive electrode connection sheet and the second positive electrode connection sheet are parallel and staggered along the second direction B to achieve partial overlapping connection. Similarly, the first negative electrode connection sheet and the second negative electrode connection sheet are parallel and staggered along the second direction B to achieve partial overlapping connection. In this embodiment, the first positive electrode connection terminal 32, the second positive electrode connection terminal 42, the first negative electrode connection terminal 33, and the second negative electrode connection terminal 43 are all configured as connection sheet structures, which are thin, compact, and enhance the stability of the overlapping connection.

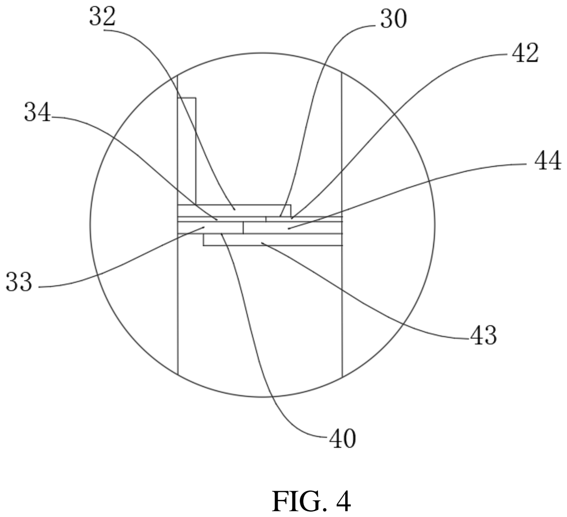

In some embodiments, referring to FIGS. 4 and 5, an overlapping area between the first positive electrode connection sheet and the second positive electrode connection sheet is defined as a first overlapping region 30, and an overlapping area between the first negative electrode connection sheet and the second negative electrode connection sheet is defined as a second overlapping region 40. The first overlapping region 30 and the second overlapping region 40 are spaced apart along the first direction A; therefore avoiding damage during subsequent connection processes caused by the relative positioning of the first overlapping area 30 and the second overlapping area 40. In some embodiments, a length of the first overlapping region 30 and/or a length of the second overlapping region 40 along the first direction A is between 2 mm and 8 mm, though the present disclosure does not limit this length.

In some embodiments, referring to FIGS. 4 and 5, the first positive electrode connection sheet and the second positive electrode connection sheet are connected by fusion, and a first fusion area between the first positive electrode connection sheet and the second positive electrode connection sheet is located within the first overlapping region 30. A length of the first fusion area along the first direction A is between 0.5 mm and 4 mm. Similarly, the first negative electrode connection sheet and the second negative electrode connection sheet are connected by fusion, and a second fusion area between the first negative electrode connection sheet and the second negative electrode connection sheet are located within the second overlapping region 40. A length of the second fusion region along the first direction A is between 0.5 mm and 4 mm.

As described above, the first overlapping region 30 and the second overlapping region 40 are spaced apart along the first direction A, and the first fusion area of the first positive electrode connecting sheet and the second positive electrode connecting sheet is located within the first overlapping area 30, while the second fusion area of the first negative electrode connecting sheet and the second negative electrode connecting sheet is located within the second overlapping area 40. Therefore, the first fusion area and the second fusion area are also spaced apart along the first direction A. This prevents high temperatures generated at the two fusion locations being relatively in the same area from damaging other structural components.

Referring to FIGS. 4 and 5, the projection of the first positive electrode connection sheet and the second positive electrode connection sheet along the second direction B is defined as a first projection, and the projection of the first negative electrode connection sheet and the second negative electrode connection sheet along the second direction B is defined as a second projection. The length of the first projection along the first direction A is equal to the length of the second projection along the first direction A. This ensures that the magnetic fields generated by the current circuit of the first positive electrode connection sheet and the second positive electrode connection sheet can cancel out the magnetic fields generated by the current circuit of the first negative electrode connection sheet and the second negative electrode connection sheet, further reducing the generation of stray inductance.

In some embodiments, referring to FIGS. 6 to 8, the length of the first positive electrode connection sheet along a third direction C is equal to the length of the first negative electrode connection sheet along the third direction C, wherein the first direction A, the second direction B, and the third direction C are mutually perpendicular. By making the length of the first positive electrode connecting piece along the third direction C the same as the length of the first negative electrode connecting piece along the third direction C, the stacked alignment of the first positive electrode connection sheet and the first negative electrode connection sheet can be ensured along the third direction C, further reducing the generation of stray inductance.

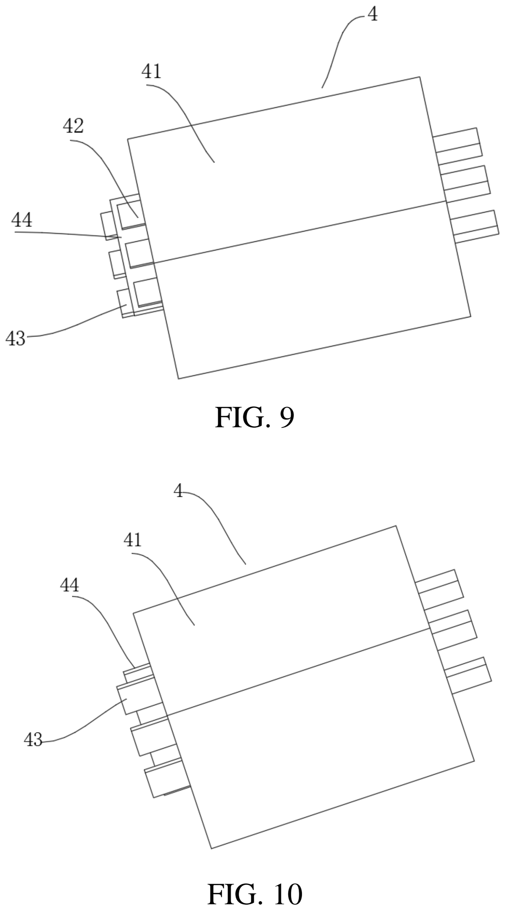

In some embodiments, referring to FIGS. 9 to 11, the length of the second positive electrode connection sheet along the third direction C is equal to the length of the second negative electrode connection sheet along the third direction C, wherein the first direction A, the second direction B, and the third direction C are mutually perpendicular. By making the length of the second positive electrode connecting piece along the third direction C the same as the length of the second negative electrode connecting piece along the third direction C, the stacked alignment of the second positive electrode connection sheet and the second negative electrode connection sheet can be ensured along the third direction C, further reducing the generation of stray inductance.

Referring to FIG. 5, the first electrical device 3 further includes a first insulation portion 34; the first insulation portion 34 protrudes from the first electrical device body 31 along the first direction A and the first insulation portion 34 is located between the first positive electrode connection terminal 32 and the first negative electrode connection terminal 33. The second electrical device 4 further includes a second insulation portion 44, the second insulation portion 44 protrudes from the second electrical device body 41 along the first direction A and the second electrical device body 41 is located between the second positive electrode connection terminal 42 and the second negative electrode connection terminal 43.

The first insulation portion 34 and the second insulation portion 44 are at least partially overlapped, and an overlapping region of the first insulation portion 34 and the second insulation portion 44 along the second direction B is a first overlapping projection. An overlapping region of the first positive electrode connection terminal 32 and the second positive electrode connection terminal 42 along the second direction B is a second overlapping projection, and an overlapping region of the first negative electrode connection terminal 33 and the second negative electrode connection terminal 43 along the second direction B is a third overlapping projection. The second overlapping projection and the third overlapping projection are located within the first overlapping projection. That is to say, the first fusion area of the first positive electrode connecting piece and the second positive electrode connecting piece, as well as the second fusion area of the first negative electrode connecting piece and the second negative electrode connecting piece, are both disposed opposite to the overlapping region of the first insulation part 34 and the second insulation part 44. On the one hand, this can effectively enhance the creepage distance and further improve the insulation performance; on the other hand, the overlapping first insulation part 34 and second insulation part 44 can effectively resist the high temperatures generated by the fusion areas, preventing damage to the first insulation portion 34 and second insulation portion 44 that may cause insulation failure.

Referring to FIG. 5, the first insulation portion 34 includes a first connecting segment 341, a second connecting segment 342, and a third connecting segment 343 which are connected in sequence; the second insulation portion 44 includes a fourth connecting segment 441, a fifth connecting segment 442, and a sixth connecting segment 443 which are connected in sequence. The second connecting segment 342 forms an angle with both the first connecting segment 341 and the third connecting segment 343, and the fifth connecting segment 442 forms an angle with both the fourth connecting segment 441 and the sixth connecting segment 443. The first connecting segment 341 and the fourth connecting segment 441 are arranged in an overlapping configuration, the second connecting segment 342 and the fifth connecting segment 442 are arranged in an overlapping configuration, and the third connecting segment 343 and the sixth connecting segment 443 are arranged in an overlapping configuration. In this embodiment, the bent configuration of the first insulation portion 34 and the second insulation portion 44 ensures their overlapping configuration.

The first insulation portion 34 may include at least one first insulation layer, and the second insulation portion 44 may include at least one second insulation layer. The present disclosure does not limit the specific structure of the first insulation portion 34 and the second insulation portion 44, nor does it limit the number of layers of the first insulation portion 34 and the second insulation portion 44. Additionally, the first insulation layer and the second insulation layer may be made of flexible materials, allowing bending and flexing without damage and facilitate the overlapping configuration between the first insulation layer and the second insulation layer.

In other embodiments, the first insulation portion 34 may be integrally injection-molded with the housing of the first electrical device body 31 or may extend from the interior of the first electrical device body 31. Similarly, the second insulation portion 44 may be integrally injection-molded with the housing of the second electrical device body 41 or may extend from the interior of the second electrical device body 41.

In some embodiments, a gap may be left between the second insulation portion 44 and the second positive electrode connection terminal 42 or the second negative electrode connection terminal 43, facilitating insertion of the first insulation portion 34 to achieve overlapping configuration with the first insulation portion 34.

In some embodiments, the spacing between the first positive electrode connection terminal 32 and the first negative electrode connection terminal 33 along the second direction B is no more than 1 mm, and the spacing between the second positive electrode connection terminal 42 and the second negative electrode connection terminal 43 along the second direction B is no more than 1 mm. This minimizes the inductive loop formed by the first positive electrode connection terminal 32, the second positive electrode connection terminal 42, the first negative electrode connection terminal 33, and the second negative electrode connection terminal 43, thereby minimizing the resulting inductance loop to reducing stray inductance.

Additionally, for the second electrical device 2, referring to FIGS. 9 to 11, multiple second positive electrode connection terminals 42 can be set up, with multiple second positive electrode connection terminals 42 spaced apart from each other along the third direction C, and multiple second negative electrode connection terminals 43 can be set up, each corresponding to one of multiple second positive electrode connection terminals 42, with multiple second negative electrode connection terminals 43 spaced apart from each other along the third direction C. Wherein the length of each of the second positive electrode connection terminals 42 along the third direction C may be equal to the length of the corresponding second negative electrode connection terminal 43 along the third direction C, ensuring the overlapping configuration of the second positive electrode connection terminal 42 and the second negative electrode connection terminal 43 along the third direction C, and further reducing the generation of stray inductance.

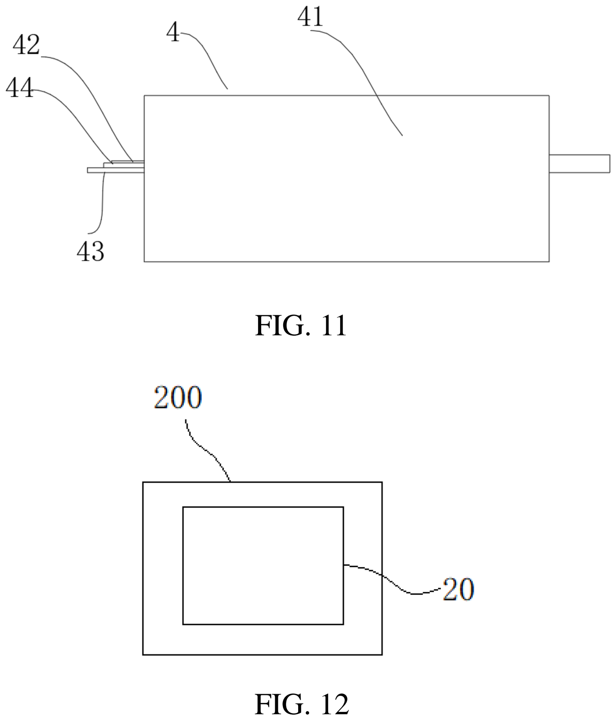

Referring to FIG. 12, the present disclosure further provides a controller 200, which includes the aforementioned electrical device assembly 20. The first electrical device 3 comprises a capacitor, where the first positive electrode connection terminal 32 serves as the positive electrode output terminal of the capacitor and the first negative electrode connection terminal 33 serves as the negative electrode output terminal of the capacitor. The second electrical device 4 comprises a power device, where the second positive electrode connection terminal 42 serves as the positive input terminal of the power device, and the second negative electrode connection terminal 43 serves as the negative input terminal of the power device.

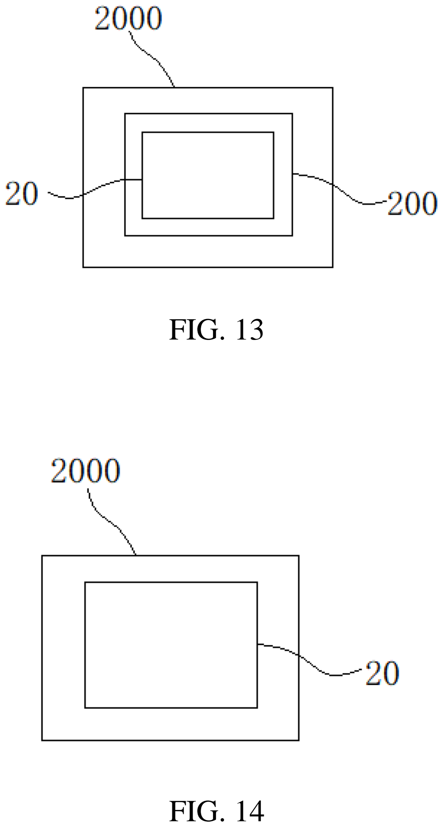

Referring to FIGS. 13 and 14, the present disclosure further provides a vehicle 2000, which includes the aforementioned controller 200 or electrical device assembly 20.

The preferred embodiments of the present disclosure have been described in detail above with reference to the accompanying drawings. However, the present disclosure is not limited to the specific details of the above embodiments. Within the technical scope of the present disclosure, various simple modifications may be made to the technical solutions of the present disclosure, and these modifications all fall within the protection scope of the present disclosure.

It should also be noted that the various technical features described in the above specific embodiments may be combined in any suitable manner without conflict. To avoid unnecessary repetition, the present disclosure does not elaborate on all possible combinations.

Furthermore, different embodiments of the present disclosure may also be combined arbitrarily, provided that such combinations do not deviate from the spirit of the present disclosure, and such combinations should also be considered as part of the disclosed content of the present disclosure.

## Claims

1. An electrical device assembly (20) comprising:
a first electrical device (3) comprising a first electrical device body (31), a first positive electrode connection terminal (32), and a first negative electrode connection terminal (33);
a second electrical device (4) comprising a second electrical device body (41), a second positive electrode connection terminal (42), and a second negative electrode connection terminal (43);
the first positive electrode connection terminal (32) and the first negative electrode connection terminal (33) both protruding form the first electrical device body (31) along a first direction (A), and the first positive electrode connection terminal (32) and the first negative electrode connection terminal (33) being stacked along a second direction (B);
the second positive electrode connection terminal (42) and the second negative electrode connection terminal (43) both protruding form the second electrical device body (41) along the first direction (A), and the second positive electrode connection terminal (42) and the second negative electrode connection terminal (43) being stacked along the second direction (B);
the first positive electrode connection terminal (32) being partially overlapped and connected with the second positive electrode connection terminal (42) along the second direction (B); the first negative electrode connection terminal (33) being partially overlapped and connected with the second negative electrode connection terminal (43) along the second direction (B); wherein the first direction (A) and the second direction (B) intersect.

2. The electrical device assembly (20) according to claim 1, wherein:
a side of the first positive electrode connection terminal (32) away from the first electrical device body (31) along the first direction (A) and a side of the second positive electrode connection terminal (42) away from the second electrical device body (41) along the first direction (A) are partially overlapped and connected along the second direction (B);
a side of the first negative electrode connection terminal (33) away from the first electrical device body (31) along the first direction (A) and a side of the second negative electrode connection terminal (43) away from the second electrical device body (41) along the first direction (A) are partially overlapped and connected along the second direction (B).

3. The electrical device assembly (20) according to claim 1 or 2, wherein:
the first positive electrode connection terminal (32) comprises a first positive electrode connection sheet, the first negative electrode connection terminal (33) comprises a first negative electrode connection sheet, the second direction (B) is a thickness direction of the first positive electrode connection sheet and the first negative electrode connection sheet, the first positive electrode connection sheet and the first negative electrode connection sheet are parallel to each other, and a projection of the first positive electrode connection sheet along the second direction (B) is at least partially overlapped with a projection of the first negative electrode connection sheet along the second direction (B);
the first positive electrode connection sheet and the second positive electrode connection terminal (42) are partially overlapped and connected along the second direction (B); the first negative electrode connection sheet and the second negative electrode connection terminal (43) are partially overlapped and connected along the second direction (B).

4. The electrical device assembly (20) according to claim 3, wherein:
the second positive electrode connection terminal (42) comprises a second positive electrode connection sheet, and the second negative electrode connection terminal (43) comprises a second negative electrode connection sheet; the second direction (B) is a thickness direction of the second positive electrode connection sheet and the second negative electrode connection sheet; a projection of the second positive electrode connection sheet along the second direction (B) is at least partially overlapped with a projection of the second negative electrode connection sheet along the second direction (B);
the first positive electrode connection sheet and the second positive electrode connection sheet are parallel and staggered along the second direction (B) to partially overlap and connect; the first negative electrode connection sheet and the second negative electrode connection sheet are parallel and staggered along the second direction (B) to partially overlap and connect.

5. The electrical device assembly (20) according to claim 4, wherein: an overlapping region between the first positive electrode connection sheet and the second positive electrode connection sheet is defined as a first overlapping region (30); an overlapping region between the first negative electrode connection sheet and the second negative electrode connection sheet is defined as a second overlapping region (40); the first overlapping region (30) and the second overlapping region (40) are spaced apart along the first direction (A).

6. The electrical device assembly (20) according to claim 5, wherein: a length of the first overlapping region (30) and/or a length of the second overlapping region (40) along the first direction (A) is between 2 mm and 8 mm.

7. The electrical device assembly (20) according to claim 6, wherein:
the first positive electrode connection sheet and the second positive electrode connection sheet are connected by fusion, and a first fusion region between the first positive electrode connection sheet and the second positive electrode connection sheet are located within the first overlapping region (30), a length of the first fusion region along the first direction (A) is between 0.5 mm and 4 mm; and/or,
the first negative electrode connection sheet and the second negative electrode connection sheet are connected by fusion, and a second fusion region between the first negative electrode connection sheet and the second negative electrode connection sheet are located within the second overlapping region (40), a length of the first fusion region along the first direction (A) is between 0.5 mm and 4 mm.

8. The electrical device assembly (20) according to any one of claims 4 to 7, wherein:
a projection of the first positive electrode connection sheet and the second positive electrode connection sheet along the second direction (B) is defined as a first projection; a projection of the first negative electrode connection sheet and the second negative electrode connection sheet along the second direction (B) is defined as a second projection; a length of the first projection along the first direction (A) is equal to a length of the second projection along the first direction (A).

9. The electrical device assembly (20) according to any one of claims 4 to 7, wherein:
a length of the first positive electrode connection sheet along a third direction (C) is equal to a length of the first negative electrode connection sheet along the third direction (C), wherein the first direction (A), the second direction (B), and the third direction (C) are mutually perpendicular; and/or,
a length of the second positive electrode connection sheet along the third direction (C) is equal to a length of the second negative electrode connection sheet along the third direction (C), wherein the first direction (A), the second direction (B), and the third direction (C) are mutually perpendicular.

10. The electrical device assembly (20) according to any one of claims 1 to 9, wherein:
the first electrical device (3) further comprises a first insulating portion (34), the first insulating portion (34) protrudes from the first electrical device body (31) along the first direction (A) and the first insulating portion (34) is located between the first positive electrode connection terminal (32) and the first negative electrode connection terminal (33);
the second electrical device (4) further comprises a second insulating portion (44), the second insulating portion (44) protrudes from the second electrical device body (41) along the first direction (A) and the second insulating portion (44) is located between the second positive electrode connection terminal (42) and the second negative electrode connection terminal (43);
the first insulating portion (34) and the second insulating portion (44) are at least partially overlapped, and an overlapping region between the first insulating portion (34) and the second insulating portion (44) along the second direction (B) is a first overlapping projection;
an overlapping region between the first positive electrode connection terminal (32) and the second positive electrode connection terminal (42) along the second direction (B) is a second overlapping projection;
an overlapping region between the first negative electrode connection terminal (33) and the second negative electrode connection terminal (43) along the second direction (B) is a third overlapping projection;
the second overlapping projection and the third overlapping projection are located within the first overlapping projection.

11. The electrical device assembly (20) according to claim 10, wherein:
the first insulating portion (34) comprises a first connecting segment (341), a second connecting segment (342), and a third connecting segment (343) connected sequentially; the second insulating portion (44) comprises a fourth connecting segment (441), a fifth connecting segment (442), and a sixth connecting segment (443) connected sequentially; the second connecting segment (342) forms an angle with both the first connecting segment (341) and the third connecting segment (343); the fifth connecting segment (442) forms an angle with both the fourth connecting segment (441) and the sixth connecting segment (443); the first connecting segment (341) and the fourth connecting segment (441) are arranged in an overlapping configuration; the second connecting segment (342) and the fifth connecting segment (442) are arranged in an overlapping configuration; the third connecting segment (343) and the sixth connecting segment (443) are arranged in an overlapping configuration.

12. A controller (200), comprising the electrical device assembly (20) according to any one of claims 1 to 11, wherein:
the first electrical device (3) comprises a capacitor, the first positive electrode connection terminal (32) are configured as a positive electrode output terminal of the capacitor, and the first negative electrode connection terminal (33) are configured as a negative electrode output terminal of the capacitor; the second electrical device (4) comprises a power device, the second positive electrode connection terminal (42) are configured as a positive electrode input terminal of the power device, and the second negative electrode connection terminal (43) are configured as a negative electrode input terminal of the power device.

13. A vehicle (2000), comprising the controller (200) according to claim 12 or the electrical device assembly (20) according to any one of claims 1 to 11.
